Europäisches Patentamt

European Patent Office

Office européen des brevets

(11) Publication number: 0 299 185 A2

# (12) EUROPEAN PATENT APPLICATION

(21) Application number: 88108683.9

(51) Int. Cl.⁴: H01L 29/78

(22) Date of filing: 31.05.88

(30) Priority: 15.07.87 US 73558

(43) Date of publication of application:
18.01.89 Bulletin 89/03

(84) Designated Contracting States:
DE FR GB IT

(71) Applicant: International Business Machines
Corporation
Old Orchard Road
Armonk, N.Y. 10504(US)

(72) Inventor: Brodsky, Marc H.
42 Manchester Drive
Mt. Kisco New York 10549(US)
Inventor: Fang, Frank F.
1691 Cardinal Court
Yorktown Heights New York 10598(US)

(74) Representative: Gaugel, Heinz, Dipl.-Ing.
IBM Deutschland GmbH Schönaicher
Strasse 220
D-7030 Böblingen(DE)

(54) Thin film field effect transistor.

(57) A thin film transistor that includes a substrate
(1); gate electrode (2); thin film semiconductor (4)
insulated from the gate electrode (2); and a bias
control electrode (9) is provided. The bias control
electrode (9) is a p-n junction or a Schottky barrier
that contacts the thin film semiconductor (4).

FIG. 1

EP 0 299 185 A2

## THIN FILM FIELD EFFECT TRANSISTOR

The present invention is concerned with a thin film field effect transistor and particularly is concerned with a thin film field effect transistor that includes bias control. The present invention makes it possible to provide bias control in a relatively simple, yet high yielding, manner. In accordance with the present invention, the bias control is provided by a p-n junction or a Schottky barrier. The present invention makes it possible to control and tailor the threshold voltage to a specified need.

Thin film field effect transistors, as well as certain techniques to control the gate threshold voltage of thin film field effect transistors, have been suggested.

For instance, Fang, "TFT Structure With Electronically Adjustable Threshold", IBM Technical Disclosure Bulletin, Vol. 20, No. 12, May 1978, p. 5352; and U.S. Patent 4,459,739 to Shepherd, et al. suggest thin film transistors having four electrodes and particularly transistors having a gate electrode located on the substrate covered by an insulator and a thin film polycrystalline semiconductor along with a bias control electrode located over the gate that is insulated from the thin film semiconductor. The bias control electrode suggested must be isolated from the conducting semiconductor layer by an insulating layer.

Another example of a thin film transistor of general interest can be found, for instance, in U.S. Patent 4,609,930 to Yamazaki.

A drawback of the thin film field effect transistors having the type of bias control suggested by Fang is the increased processing and particularly for forming the insulating layer beneath the bias electrode that contributes to increasing the complexity of the process, as well as reducing the yield.

The present invention is concerned with a thin film field effect transistor having a bias control.

In particular, the present invention provides for a simpler manner in which to provide bias control in a thin film field effect transistor, along with achieving increased yield.

Moreover, the present invention eliminates the need for an insulating layer between the bias control and the semiconductor layer.

In particular, the objectives of the present invention are achieved by providing as the bias control electrode a p-n junction or a Schottky barrier that directly contacts the thin film semiconductor.

More particularly, the present invention is concerned with a thin film field effect transistor that comprises a substrate; a gate electrode; a thin film semiconductor material that is insulated from the gate electrode; and a bias control gate electrode.

The bias control gate electrode forms a p-n junction or a Schottky barrier that contacts the thin film semiconductor material. The thin film semiconductor material is located intermediate the gate electrode and the bias gate control electrode.

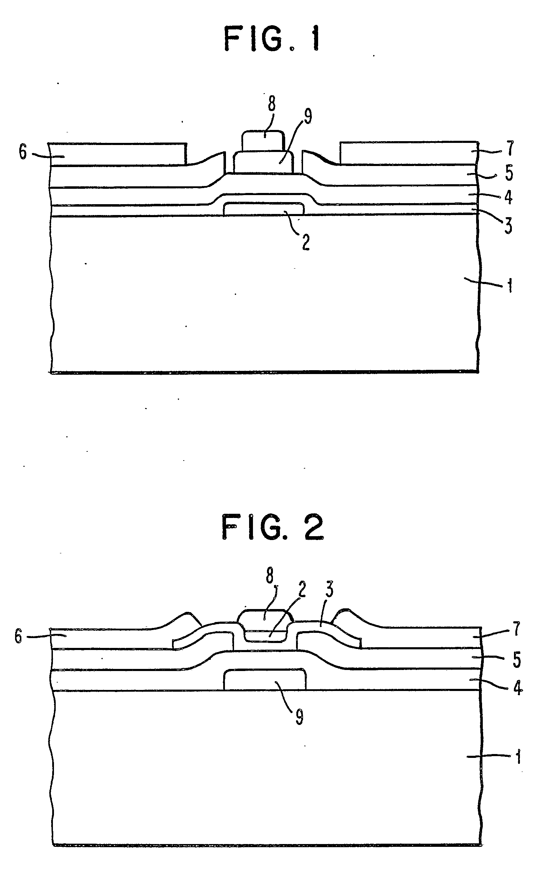

Figures 1 and 2 are schematic diagrams illustrating thin film field effect transistors of the present invention.

To facilitate understanding of the present invention reference will be made to Figures 1 and 2. When reference is made to impurities of a "first type" and to impurities of a "second type", it is understood that the "first type" refers to n-type or p-type impurities and "second type" refers to the opposite conductivity type. That is, if the first type is p, then the second type is n. If the first type is n, then the second type is p. It also being understood that when reference is made to an n-type impurity, the present invention is just as applicable to use of a p-type impurity and vice versa. In other words, when reference is made to an n-type impurity as the first impurity type and p-type is the second and different impurity type, the present invention is also applicable to the first impurity type being p-type and the second impurity type being n-type and vice versa.

Figure 1 illustrates a thin film field effect transistor within the scope of the present invention that employs as the bias control electrode a p-n junction that contacts the thin film semiconductor material. In particular, numeral 1 refers to the substrate of the thin film field effect transistor such as a glass substrate. Located on substrate (1) is a gate electrode (2) and includes metals such as aluminum or chromium. The gate electrode (2) can be provided by any known technique on the substrate such as by vacuum evaporation or sputter deposition. Typical thicknesses of the metal gate electrode are about 50 nm to about 150 nm an example of which is about 100 nm. An insulator lazer (3) is located above and conformable with the gate electrode (2). The insulator layer (3) is to insulate the gate electrode (2) from a thin film semiconductor material (4). Typical insulating layer materials include silicon dioxide and silicon nitride, the preferred of which is silicon dioxide. The silicon dioxide or silicon nitride insulator layer is usually hydrogenated silicon dioxide or hydrogenated silicon nitride, respectively, when the semiconductor is hydrogenated amorphous silicon. The insulator layer is typically about 50 nm to about 100 nm thick. The insulator layer can be deposited by any of the known techniques for depositing such materials including chemical vapor deposition. The deposition process for forming the insulator is usually similar to that for forming the semiconductor, such as plasma deposition or chemical vapor deposition for hydrogenated amorphous silicon or polycrystalline silicon, respectively.

Located above the insulator layer (3) is shown the layer of semiconductor material (4) doped with a dopant of first type. The semiconductor layer can be, for example, polycrystalline silicon or hydrogenated amorphous silicon. The semiconductor layer is usually about 60 nm to about 300 nm thick, and typically about 200 nm thick. The hydrogenated amorphous silicon layer or polycrystalline silicon layer can be formed by well-known techniques. For instance, the hydrogenated amorphous silicon layer can be provided by well-known plasma deposition techniques such as placing the structure in a plasma reaction chamber using silane as the source of the hydrogenated amorphous silicon. The source of the hydrogenated amorphous silicon can be 100% silane or, if desired, such can be diluted with an inert gas such as helium, neon, argon, and krypton or diluted with hydrogen or nitrogen. Other methods for depositing hydrogenated amorphous silicon such as those disclosed in U.S. Patent 4,363,828 to Brodsky, et al. can be employed.

The polycrystalline silicon can be formed by chemical vapor deposition and doped by conventional techniques.

The semiconductor layer can be doped with a first type dopant such as an n-type dopant by such techniques as adding a dopant bearing gas to the silane during deposition. When the semiconductor material is amorphous silicon or polycrystalline silicon, the n-type dopant can be arsenic, phosphorus, or antimony. Typical levels of doping are about $10^{16}$ cm$^{-3}$ to about $10^{17}$ cm$^{-3}$. However, if desired, the doping can be p-type. Examples of p-type dopants for amorphous silicon and polycrystalline silicon are boron, gallium, aluminum, and indium. The preferred n-type dopant is phosphorus, obtainable from phosphine during deposition of the semiconductor layer. The preferred p-type dopant is boron, obtainable from diborane during deposition of the semiconductor layer.

Above layer (4) is defined the thin film semiconductor material (5) in a predetermined pattern. The thin film semiconductor material can be, for example, polycrystalline silicon or hydrogenated amorphous silicon. Also, the hydrogenated amorphous silicon can include such additives as germanium and carbon as known. The semiconductor layer (5) is heavily doped with an n-type dopant. The dopant in semiconductor layer (5) is usually present in amounts ob about $10^{19}$ cm$^{-3}$ to about $10^{21}$ cm$^{-3}$. The thin film semiconductor layer (5) is typically about 30 nm to about 250 n. thick and more typically about 100 nm thick. In the case of n-type doping in layer (5), an n-channel transistor is provided. However, if desired, the layer (5) can be doped with a p-type dopant to provide a p-channel thin film transistor device.

Biasing gate (9) can form a p-n junction with that portion of layer (4) contacted therewith. Bias gate electrode (9) can be polycrystalline silicon, or hydrogenated amorphous silicon doped with a dopant of the second type such as a p-type dopant when layer is doped with an n-type dopant. P-type dopants include boron, aluminum, gallium and indium, and typically is boron. The amount of doping is usually between about $10^{19}$ cm$^{-3}$ and about $10^{21}$ cm$^{-3}$. Substrate biasing gate (9) is usually about 100 nm to about 300 nm thick, and typically about 200 nm thick.

When semiconductor layer (4) is p-type doped, then substrate biasing gate (9) will be n-type doped in order to provide the n-p junction.

Instead of a p-n junction, biasing gate (9) can provide a Schottky barrier by employing a metal such as platinum, palladium, gold, aluminum, chromium, hafnium, molybdenum, or an electrically conductive intermetallic compound, such as a silicide of these metals. When the biasing is provided by a Schottky barrier, the semiconductor layer (9) on the layer (4) above the gate can be eliminated if desired.

Source, drain, and bias electrode metallic type contacts are illustrated as numerals 6, 7 and 8, respectively. These contacts can be any deposited metal such as aluminum or chromium and are generally about 100 nm to about 300 nm thick, and typically about 200 nm thick. A metallic type contact (not shown) to the gate electrode (2) is provided as is apparent to those skilled in the art.

Figure 2 illustrates another embodiment within the scope of the present invention wherein the bias gate electrode is located adjacent the substrate and the gate electrode (2) is located above the bias electrode. In particular, the substrate is represented by numeral 1 and contacting the substrate is the substrate bias electrode (9). The bias electrode (9) can provide a p-n junction with layer (4) adjacent thereto or can be of the Schottky barrier type. Layer (4) is a semiconductor layer such as hydrogenated amorphous silicon or polycrystalline silicon which is lightly doped with a dopant opposite type that in the biasing electrode (9). For instance, when bias electrode (9) is a semiconductor doped with an n-type dopant, layer (4) will be doped with a p-type dopant and vice versa. In the case of a Schottky barrier as the biasing electrode, the semiconductor layer (9) is replaced by the appropriate metal to form the Schottky barriers with the semiconductor layer (4).

A heavily doped, thin film semiconductor layer (5) is defined by conventional lithographic techniques and can be hydrogenated amorphous silicon or polycrystalline silicon heavily doped with an n-type or p-type dopant. In the case of n-type doping an n-channel device is provided, and with p-type doping a p-channel is provided. An insulating layer (3) is provided to isolate, but capacitively couple to, the moderately doped channel semiconductor layer (4) from the gate electrode (2) and to isolate electrically the heavily doped semiconductor layer (5) from gate electrode (2). Gate electrode (2) can be any conductive material such as aluminum or chrome. Source, drain, and gate contacts are illustrated at numerals 6, 7, and 8, respectively and are defined by means of conventional lithographic technique. A metallic type contact (not shown) to biasing electrode (9) is provided as is apparent to those skilled in the art.

## Claims

1. A thin film field effect transistor comprising a substrate (1); gate electrode (2); a thin film semiconductor material (4) insulated from said gate electrode (2); and a bias control electrode (9) that forms at least one of a p-n junction and a Schottky barrier contacting said thin film semiconductor material (4) and wherein said thin film semiconductor material (4) is located intermediate said gate electrode (2) and said bias control electrode (9).

2. The thin film field effect transistor of claim 1 wherein said gate electrode (9) is located adjacent said substrate (1).

3. The thin film field effect transistor of claim 1 wherein said bias control electrode (9) is located adjacent said substrate (1).

4. The thin film field effect transistor of claim 1 or 2 wherein said substrate (1) is glass.

5. The thin film field effect transistor of claims 1 to 4 wherein said semiconductor material (4) is polycrystalline silicon, amorphous silicon, or hydrogenated amorphous silicon.

6. The thin film field effect transistor of claims 1 to 5 wherein said bias control electrode is a p-n junction.

7. The thin film field effect transistor of claims 1 to 6 wherein said gate electrode is a metal.

8. The thin film field effect transistor of claim 7 wherein said gate electrode is aluminum or chromium.

9. The thin film field effect transistor of claims 1 to 8 wherein said thin film semiconductor material (4) is insulated from said gate (2) electrode by a layer (3) of silicon dioxide, or silicon nitride, or both.

# FIG. 1

# FIG. 2